Europäisches Patentamt

European Patent Office

Office européen des brevets

(19)

(11) EP 1 400 918 A1

(12) **EUROPEAN PATENT APPLICATION**

(43) Date of publication:
24.03.2004 Bulletin 2004/13

(51) Int Cl.$^7$: **G06K 11/08**

(21) Application number: 02020888.0

(22) Date of filing: 18.09.2002

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **SIEMENS AKTIENGESELLSCHAFT**
**80333 München (DE)**

(72) Inventors:
• **Gobel, Bent Richardt**
**7600 Struer (DK)**
• **Hoyer, Michael**
**9200 Aalborg SV (DK)**

(54) **Input device and input method**

(57) User input is detected by i) emitting light, ii) positioning an object (200) close to a surface (102), iii) detecting light reflected by said object due to frustrated total internal reflection from said object, iv) generating a signal in responsive to said detecting step, and v) assigning an input value 1) in response to the signal (SIG), or 2) responsive to a device in which the detecting step is performed.

FIG 2 (RIGHT)

## Description

## Field of the invention

The invention relates generally to obtaining user input for an electronic device. More specifically, the invention relates to obtaining user input with an optoelectronic arrangement.

## Background of the invention

The still growing number of users of mobile terminals together with the high competition on the market set very high requirements for the design of mobile terminals. On one hand, the manufacturing process has to be easy and the assembling procedure with all components required has to be cost effective. On the other hand, consumers expect the new terminals to include lucrative and fascinating properties and to have an aesthetically pleasing design.

One of the components having a large impact on the consumers' decision whether or not to buy a specific device is the input mechanism, such as the keyboard or dialling buttons of the mobile terminal. Some manufacturers have mobile terminals which include an illuminated dialling keypad. The mechanical construction uses either micro switches or foil-based switched, many lacking the comfort of use. The design gets even more challenging when such a device should reuse a maximal number of terminal components already existing, and still have an aesthetically acceptable outlook.

Different solutions trying to improve the comfort of use of a keyboard or a dialling pad had been the subject of some published patent applications, for example, of DE 199 56 063 A1 and US 2002/0,050,975 A1.

The published German patent application DE 199 56 063 A1 discloses a keyboard mechanism. The idea of '063 is that by pressing a key the user interrupts an optical signal transmission between a sender and a receiver element tied under the key. This, on its behalf, makes it necessary for the keyboard to be mechanically movable thus reducing its reliability and making the mechanical implementation more complex. A mechanically robust keyboard is preferable for non optimal usage conditions which may include not only mechanically hard shocks but also moisture or other similar dangers for the device wherein the input device is to be used.

In the published US patent application US 2002/0,050,975 A1 a method for increasing the attractivity of a device is disclosed. In '975 solution the back light sources of a display of a device are used for keyboard illumination. The light from the light sources is guided by optical fibres. The colour of the lights may be changed, and so on. The purpose of the '975 solution is to increase comfort of use especially in environments only low ambient light level.

It is an object of the invention to bring about a novel input device and method, both being easy and cost-effective to manufacture and having a size suitable for use in a mobile terminal, and by using which it is possible to provide portable devices having a nice outlook. Another objective of the invention is to bring about a new input method, possibly even reusing some existing hardware components.

## Summary of the invention

This and other objectives of the invention are accomplished in accordance with the principles of the present invention by providing an input device and an input method.

An input device comprises i) at least one light source, ii) at least one detector having a detection area sensitive for light emitted by said light source, the detector being adapted to detect a reflection of the light emitted by said light source, the reflection being caused by an object positioned close to the detector area, adapted to generate a signal responsive to said detection of the reflected light, and iii) means for assigning an input value 1) in response to the signal, or 2) depending on the detector producing the signal. Using such a construction a waterproof device, possibly having even a fancy, futuristic and trendy design is obtained. The device is more reliable since no or only a small number of mechanically moving parts are involved.

According to one aspect of the invention, the device may further comprise iv) light conductive medium adapted to conduct light emitted, the light conductive medium including at least one surface, the surface adapted to reflect light under total reflection conditions in absence of the object, and to allow the light under total reflection conditions to pass through the surface in presence of the object close to the surface, the object thereby reflecting light, part of which is detected by the detector. Such a device provides the user with a convenient and effective input mechanism, and it is possible to build the device in such a way that enables more efficient reuse of device components thereby reducing or removing the need of mechanical switches, for example.

An input method comprises the steps of i) emitting light, ii) positioning an object close to a surface, iii) detecting light reflected by said object, iv) generating a signal in responsive to said detecting step, and v) assigning an input value 1) in response to the signal (SIG), or 2) responsive to a device in which the detecting step is performed.

According to one aspect of the present invention, the method may further comprise the step of conducting light into inside a light conducting medium which reflects light under total reflection conditions in the absence of the object, and to allow the light pass through the surface in presence of the object close to the surface, the presence of the object at least partly removing the total reflection conditions, the object thereby reflecting light, part of which is detected by the detector.

According to one aspect of the present invention, an input device comprises i) a light source emitting light of at least one wavelength λ, ii) a substrate in communication with said light source for guiding the light of wavelength λ by total internal reflection, iii) an input area located on an outer surface of the substrate, iv) detector means for detecting the presence of an object on or at a distance $d \le \lambda$ above said input area by measuring intensity of light reflected or scattered by said object, and v) means for generating a signal indicating an input action whenever the measured intensity of the reflected or scattered light changes by a predetermined amount or exceeds a predetermined threshold.

**Brief description of the drawings**

In the following, the invention and its preferred embodiments are described more closely referring to the examples shown in Figures 1 to 8 in the appended drawings wherein:

Figure 1     illustrates an embodiment of the input device according to the invention,

Figure 2     illustrates how an input is fed to the input device,

Figure 3     illustrates the propagation of five light rays enter into light conducting medium 105 from the left end in the absence of the object 200,

Figure 4     illustrates the behaviour of one of the light rays when the object 200 is in the vicinity of the light conducting medium 105 causing total frustrated internal reflection,

Figure 5     shows a block diagram including some blocks typically contained in a mobile device,

Figure 6     illustrates the basic blocks user interface blocks of a mobile device 600,

Figure 7     illustrates one embodiment of the invention applied to a mobile device 600, and

Figure 8     illustrates the second embodiment of the present invention applied to a mobile device 600.

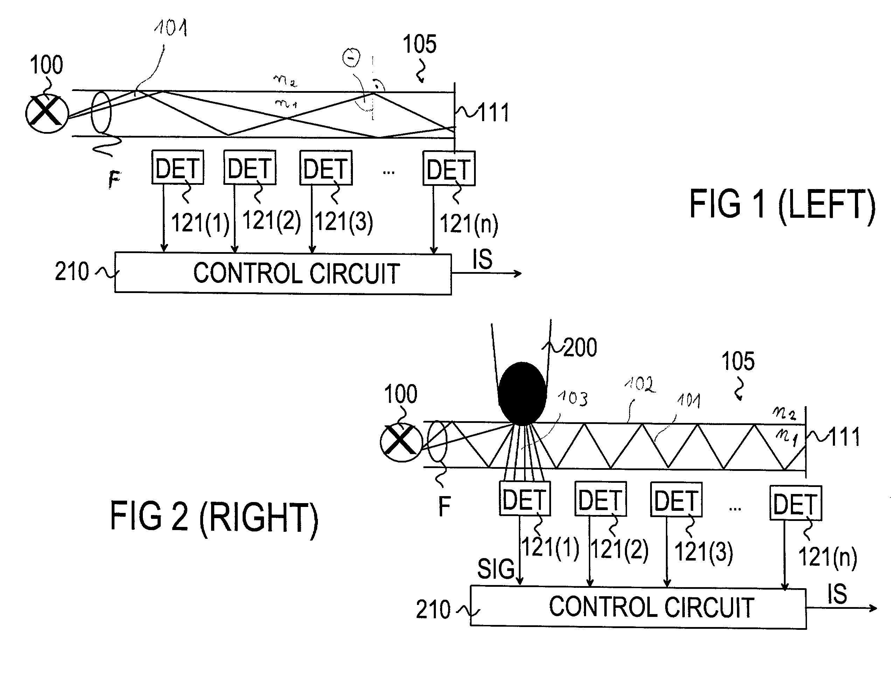

Like reference signs refer to corresponding parts and elements throughout Figures 1-8.

**Detailed description of the invention**

Figure 1 illustrates the basic blocks of the input device. Light 101 is emitted by a light source 100 which may be a light emitting diode LED or any other suitable source of light, such as an electro-luminescent strip or miniature fluorescent tube.

The light source 100 emits a total flux F of light 101 into light conductive medium 105 which may be of glass or plastic. Suitable materials are some single polymers, and even suitable block copolymers, which may include some doping giving the optical characteristics desired. One of the easiest solutions is to use a plastic rod as the light conductive medium 105. Physically, the light conductive medium can act as optical substrate.

The light 101 emitted from the light source 100 is trapped within the light conductive medium 105. Preferably, the light 101 from the light source 100 is introduced via an input face that can be understood to be located on the left-side of the light conductive medium 105. The light 101 is introduced in a prescribed manner such that the conditions for total internal reflection, i.e.

$$n_1 \sin \theta > n_2, \; n_1 > n_2$$

are satisfied for all wavelength components of the light 101. $n_1$ is the refractive index of the light conducting medium 105, $n_2$ is the refractive index of the surrounding medium, and θ is the angle of incidence of the light 101 with respect to the normal to an upper surface and bottom surface of the light conducting medium 105. Typically, for air $n_2 = 1$, and for silicon dioxide $n_1 = 1,5$, thereby the critical angle for total internal reflection is about $\theta_c \approx 41,8°$. For other materials, the applicable refractive indices can be found in almost any optics handbook available.

Because the light 101 is trapped within the light conductive medium 105, it propagates in there. The intensity of light within the light conductive medium 105 may be temporarily increased by placing a reflector 111 at one end of the light conductive medium 105. The reflector 111 may be a mirror or a polished piece of metal, for example, and it reflects light trapped in the light conductive medium 105 back in the direction of the light source 100.

Furthermore, the input device comprises at least one detector 121. In case that several different input values are desired, the input device may comprise a plurality of detectors 121 which can be positioned along the light conductive medium 105 so that each one of the detectors 121 correspond to a single detector 121 (1), 121(2), 121(3), ..., 121(n) in an array of detectors 121.

The purpose of the detectors 121 is to record or detect an input given by the user. The detectors 121 are connected to means 210 for assigning an input value IS in response to a signal obtained from the detector 121. The means 210 for assigning an input value may include a control circuit.

Figure 2 illustrates one possibility for giving an input by the input device in a manner according to the present invention. An object 200, such as a user's finger, a pen, or some other object is positioned close or opposite to the detector 121 on the input side 102 of the light conductive medium 105. In the example of Figure 2, the object 200 is positioned opposite to the detector 121(1). The detector 121(1) produces a signal SIG responsive to the detection of light 103 reflected from the object 200. Preferably, the reflection of the light 101 to be detected is created by frustrated total internal reflection FTIR from the object 200. The means 210 for assigning an input value generate an input signal IS in response to the signal SIG.

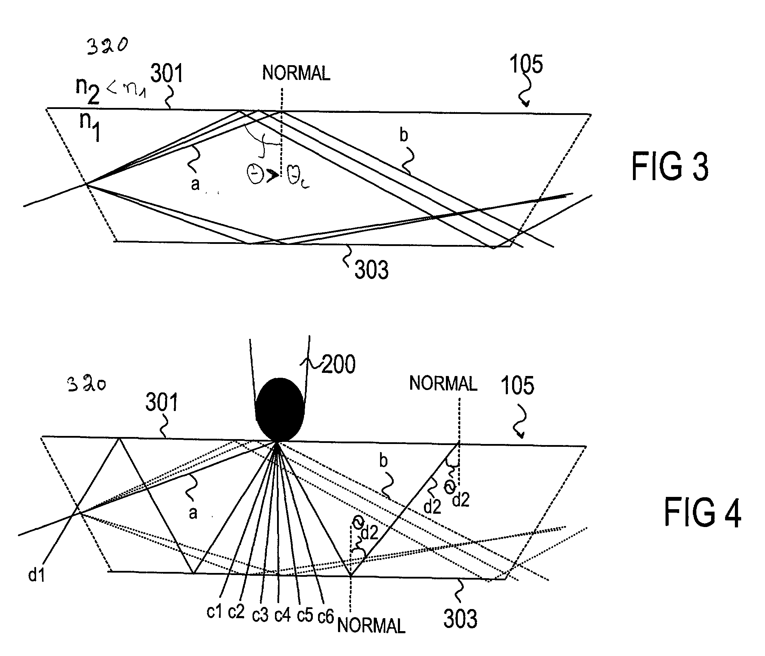

Figure 3 illustrates a cut of light conductive medium 105. The light conductive medium 105 has an upper surface 301 corresponding to the input side and a lower surface 303 corresponding to the detector side. Illustrated are five rays of light. As seen, the light ray A is totally reflected from the upper surface 301 of the light conductive medium 105. The reflected ray of light is denoted by B. The reason for the total reflection is that the angle of incidence $\theta$ between the incident ray A and the normal of the upper surface 301 is greater than the critical angle $\theta_c$ of total internal reflection. A prerequisite for this is that the surrounding media 320 has a smaller refractive index $(n_2 < n_1)$. Typically, the angle $\theta$ depends on the material and on the wavelength.

Figure 4 illustrates the effect caused when the total internal reflection within the light conductive medium 105 changes to total frustrated internal reflection when the object 200 touches the upper surface 301. This is analogous to the quantum mechanical phenomenon of electron tunnelling. The electric field corresponds to the electron wave function, and the transmitted power corresponds to the probability density. Thus, in the same manner that an electron can tunnel through a potential barrier, photons can do the same across a small spatial gap. Evidently, this small spatial gap is then located between the object 200 and the top surface 301 of the light conductive medium 105.

In Figure 4, the other light rays of Figure 3 are printed with dotted lines. Only the light ray A from the light rays in Figure 3 is drawn using a solid line. The path of the light total reflected ray A is marked with dash-dotted line B as in Figure 3, because of the frustrated total internal reflection the light ray A does not form the totally reflected ray B. Instead of being totally reflected, it partly tunnels through the upper surface 301 of the light conductive medium 105. A substantial part of the photons of the light rays is then reflected from a small region of the object 200 being reasonably close to or in contact with the top surface 301 of the light conductive medium 105. The reflections can be approximated to extend to a semi-sphere covering the spatial angle $2\pi$ viewed from the point of incidence on the object 200. These reflected light rays marked with C1, C2, C3, C4, C5, C6 can extend through the bottom surface 303 of the light conductive medium 105. It is these light rays C1 to C6 that are detected by the detector 120. Of course, not all light rays reflected from the object 200 are detected. Especially true this is in the case of light rays D1, D2, for which the angle of incidence $\theta_{D1}$, $\theta_{D2}$ between to the normal of the bottom surface 303 of the light conductive medium 105 and the angle of incidence of the light ray D2 exceeds the critical angle $\theta_c$ of total internal reflection, as is the case for the light ray D1 as well. Light ray D2 propagates towards the direction of the original light ray A whereas the light ray D1 propagates backwards in the light conductive medium 105. The light rays D1 and D2 are trapped in the light conductive medium 105.

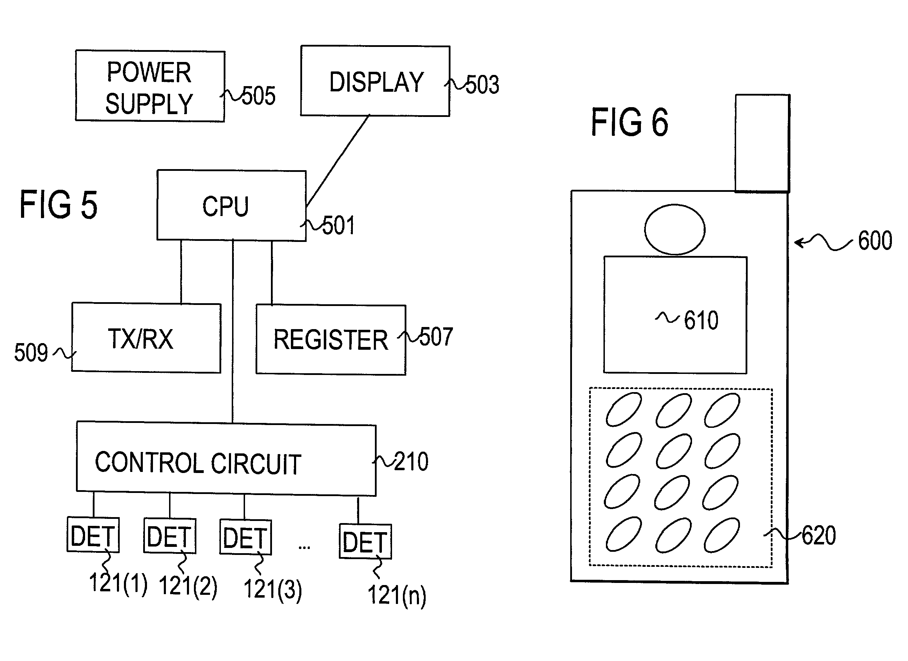

Figure 5 illustrates a simplified block diagram of the functional elements included in a typical mobile device. An example of such a device is a mobile terminal such as a GSM or UMTS phone. The heart of the mobile device is formed by its processing means 501, such as a central processing unit usually being a micro processor. Further, the mobile device includes a display 503 for presenting information to the user. Power supply 505 supplies the device with electricity. Register 507 is used for saving data, such as telephone numbers, comments, and instructions received from the user. The sending and receiving TX/RX means 509 take care of the transfer of information over the air interface. They may include also other communication means, such as an infra-red or a low power radio frequency chip, such as those used for BLUETOOTH communications.

A typical mobile device comprises also means for assigning an input value for input coming from the keyboard. In a conventional mobile device the means for assigning an input value correspond to an electronic circuit which transforms the electronic signals coming from the keyboard or keypad switches to the control circuit.

According to one aspect of the present invention, the dialling and/or functional keys of the keypad are replaced with light conducting medium 105, and the micro or foil switches of keys are replaced by detectors 121. Similarly, the traditional control circuit of the mobile device is replaced by means 210 for assigning an input value which are adapted to generate an input signal IN on the basis of signals received from detectors 121.

Figure 6 is a simplified mobile terminal 600. The simplified mobile terminal 600 includes a display module 610 and a keypad module 620. It is to be understood that the blocks discussed with reference to Figure 5 are included in the mobile device 600. Figure 6 merely illustrates the user interface parts of the mobile phone 600.

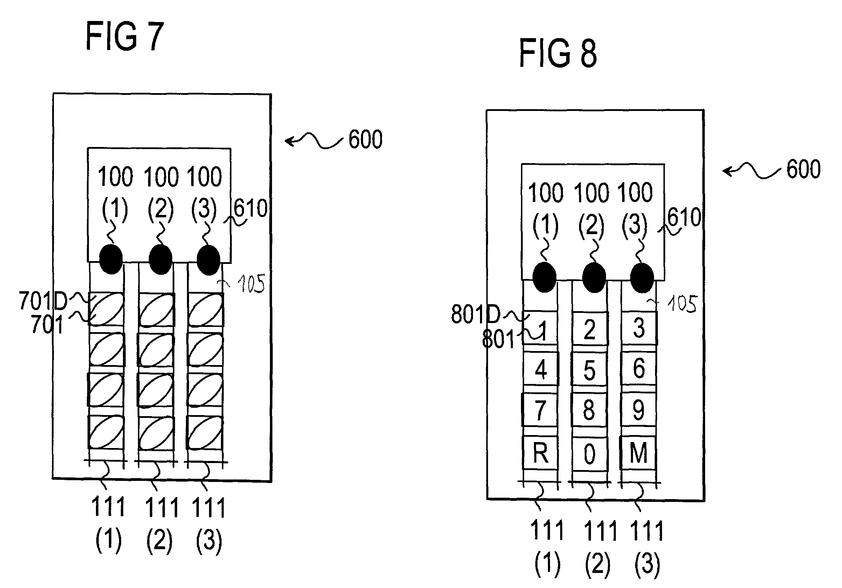

Figure 7 presents one possible construction of using the inventive input device within a mobile device 600. The keypad 620 of the mobile device 600 is now implemented using input devices as described above. The mobile device 600 may include one or more light conductive medium 105. In Figure 7, the number of light conductive media 105 is three. In principle instead of using separate light conductive media 105 a longer bendable light conductive medium 105 could be used thereby reducing the number of the light conductive media 105 needed.

As light sources 100 for the input devices act the three light sources 100(1), 100 (2), 100(3) which are the light sources normally used in the display 110 of the mobile device 600. At least part of the light emitted by the light sources 100 is thereby trapped into the light conductive media 105. These light sources can still be used for illuminating the display or giving the display back light thus contributing to providing components multiple functionality.

One possibility is to use keypad back lights as light sources 100. Each light conductive medium 105 includes a reflector 111 at the end of the light conductive medium 105. The purpose of the reflectors 111 is to increase the amount of light within the light conductive medium 105.

The keypad can be implemented in such a way that the keys 701D include a substantially transparent part 701. The idea is that the user gives input by placing an object 200 in the vicinity of the transparent part 701. Placing of this object 200 on the substantially transparent part 701 causes the frustrated total internal reflection as described above which then can be detected in the detector 121.

The cover of the mobile device may be transparent as well. This has the advantage that especially in the dark or in bad light conditions the device has a fancy outlook.

Figure 8 illustrates another possibility for implementing input devices according to the present invention to a mobile device 600. The main difference to the embodiment shown in Figure 7 is that now the keys include printings 801 such as numbers or functional tasks of the mobile terminal 600. The background 801D of each printing 801 of the keys may be made transparent or substantially transparent. The top surface 301 of the light conductive medium 105 is to be understood to be located directly under the back part 801D. Similarly, the detectors 121 may be positioned along the light conductive medium 105 between the light source 100 and the reflector 111. As in the example of Figure 7 the light conductive media 105 may again be arranged in an array.

The light conducting medium 105 for such an input device which contains an array of input devices, the light conducting media 105(1), 105(2), ..., 105(n) can be made to consist of one piece. Suitable material is transparent polyacrylate, for example. The polyacrylate substrate can be moulded or cast in one piece, thus having a curved form at the ends of each light conducting medium 105(1), 105(2), ..., 105(n). The condition for total internal reflection is not necessarily satisfied at the curved points. This is compensated by using the display backlight sources as the light sources 100(1), 100(2), ..., 100(n) which are positioned in a row with corresponding separation to produce a high enough light flux into the light conducting medium 105(1), 105(2), ..., 105(n). Therefore also no reflector 111(1), 111(2), ..., 111(n) is necessary.

The detectors 121(1), 121(2), ..., 121(n) from a group of suitable detectors showing low enough current consumption and high enough sensitivity therefore enhancing the standby time of the device 600 wherein the input device is going to be installed. Similarly, the low sensitivity helps to keep the output power of the light sources 100(1), 100(2), ..., 100(n) low enough.

One possible size of the detectors 121(1), 121 (2), ..., 121(n) is approximately 3 mm x 3 mm. Because the detectors 121(1), 121(2), ..., 121(n) are located in the vicinity of the points where the object 200 is estimated to be positioned, the sense angle being then about 60° (as a projection to 2D), therefore making the sensitive spot for the object on the top surface 301 about 5 mm x 5 mm being enough for a normal-size finger tip of an average user.

The detectors 121(1), 121(2), ..., 121(n) can be assembled together with the light conductive media 105(1), 105(2), ..., 105(n) so that they together form a module which is ready to be installed into a device 600. The positioning of the device is done so that the light sources 100(1), 100(2), ..., 100(n) are in a good position. The connection of the input device can be made through the control circuit 210.

The cross section of the conducting medium 105 can be a rectangular (or square) shaped plastic, the size of each side being between 1 and 2 millimetres. The length of the light conducting means 105 can then be adjusted to comply with the other measures like the size of the front part of the phone. In another embodiment, the light conducting medium 105 is the upper part of the phone housing, thereby enabling possible the changing of the cover and the input device when they get to be worn out, e.g. due to scratches. Further, the light conducting medium can be illuminated by a number of LEDs also located in the lower end of the phone.

Although the invention was described above with reference to the examples shown in the appended drawings, it is obvious that the invention is not limited to these but may be modified by those skilled in the art without difference from the scope and the spirit of the invention.

**Reference List**

| | |
|---|---|
| 100 | light source |
| 101 | light |
| 102 | input side of the light conductive medium 105 |
| 103 | light reflected or scattered by object 200 |
| 105 | light conductive medium |
| 111 | reflector |
| 121 | detector |
| 200 | object |
| 210 | means for assigning an input value |
| 301 | upper surface |
| 303 | bottom surface |

| | |
|---|---|
| 320 | surrounding medium |
| 501 | processing means |
| 503 | displaying means |
| 505 | power supply |
| 507 | register |
| 509 | send/receive part |
| 600 | mobile device |
| 610 | display |
| 620 | dialling pad |
| 701 | centre position of the input device |
| 701D | surface of the input device |
| 801 | printing |
| 801D | key corresponding to the printing 801 |
| F | light flux entering into the light conductive medium |
| SIG | signal |
| IS | input value |
| $n_1$ | refractive index of the light conductive medium 105 |
| $n_2$ | refractive index of the surrounding medium 320 |
| $\theta_c$ | critical angle for total internal reflection |
| $\theta$ | angle of incidence |

**Claims**

1. An input device, the input device comprising:

   - at least one light source (100);
   - at least one detector (121) having a detection area sensitive for light emitted by said light source (100), the detector (121) being adapted to detect a reflection (103) of the light emitted by said light source (100), the reflection being caused by an object (200) positioned close to the detector (121) area, adapted to generate a signal (SIG) in response to said detection of the reflected light; and
   - means (210) for assigning an input value i) in response to the signal (SIG), or ii) depending on the detector (121) producing the signal (SIG).

2. A device according to claim 1, wherein the system further **comprises:**

   - light conductive medium (105) adapted to conduct light emitted, the light conductive medium (105) including at least one surface (301, 303), the surface (301, 303) adapted to reflect light under total reflection conditions in absence of the object (200), and to allow the light under total reflection conditions to pass through the surface in presence of the object (200) close to the surface (301, 303), the object (200) thereby reflecting light, part of which (103) is detected by the detector (121).

3. A device according to claim 2, further **comprising:** a reflector (111) at one end of the light conductive medium (105) for increasing the amount of light (101) in said light conducting medium (105) .

4. A device according to any one of the preceding claims, **wherein:** a portion of the surface (301, 303) in the vicinity of the detector (121) includes an area (401) of substantially transparent matter.

5. An input device according to claim 1, 2, 3, or 4, **wherein:**

   - the input device includes a plurality of detectors (120), the input value being responsive to which detector (120) the object (200) is positioned to.

6. An input device according to claim 1, 2, 3, 4, or 5, **wherein:**

   - said reflection of the light to be detected is frustrated total internal reflection from the object (200) .

7. A device according to any one of the preceding claims, **wherein:** the light conducting medium (105) is an optical fibre, or consists of at least one polymer.

8. A device according to any one of the preceding claims, further **comprising:** a control circuit (210) for handling the signal (SIG) produced by the detector 121, thus producing an input signal (IS).

9. A device according to anyone of the preceding claims, the device further **comprising:**

   - processing means (501) adapted to use the input value assigned by means (210) to represent a user input, such as a number, a characters, and/or an operational commands.

10. A system of input devices **characterised in that** the system includes:

    - a plurality of input devices according to the preceding claim 2 or 3, wherein light conducting media (105) of single input devices are positioned into at least one array.

11. A mobile device (600) **characterised in that** the mobile device (600) includes an input device according to any one of the preceding claims.

12. A mobile device (600) according to claim 11, **wherein:**

said light source (100) is a light source (100) used for illuminating the display (610) of the mobile device (600).

13. A mobile device (600) according to any one of the preceding claims 11-12, **wherein:** a cover of the mobile device (600) is substantially transparent at a center (701) position of the input device such as a dialing pad (620) .

14. A mobile device according to any one of the preceding claims 11-12, **wherein:** a cover of the mobile device (600) includes a printing (801) and a key (801D) corresponding to the printing (801) is substantially transparent.

15. An input method **comprising** the steps of:

- emitting light;
- positioning an object (200) close a surface;
- detecting light reflected by said object (200);
- generating a signal (SIG) in responsive to said detecting step; and
- assigning an input value i) in response to the signal (SIG), or ii) responsive to a device in which the detecting step is performed.

16. A method according to claim 15, the method further **comprising** the step of:

- conducting light into inside a light conducting medium (105) adapted to reflect light under total reflection conditions in absence of the object (200), and to allow the light under total reflection conditions to pass through the surface in presence of the object (200) close to the surface (301, 303), the object (200) thereby reflecting light, part of which is detected by the detector (121).

17. A method according to claim 16, further **comprising** the step of: reflecting light back to the conducting step after it has exited the conducting step for increasing the amount of light available for the detecting step.

18. A method according to claim 15, 16, or 17, **wherein:**

- the step of assigning the input value is performed responsive to means in which the detecting step is performed further depending on a position of the object (200) in the positioning step.

19. A method according to any one of claims 15-18, **wherein:**

said reflection is frustrated total internal reflection from the object (200).

20. A method according to any one of the preceding claims 15-19, **wherein:** the light conducting step is performed in an optical fibre, or in a medium consisting of at least one polymer.

21. A method according to any one of the preceding claims 15-20, further **comprising** the step of: processing the input value to represent a user input, such as a number, a character, and/or an operational commands.

22. An input method
**characterised in that**
the method includes the step of: using the input method in accordance with the preceding claim 16 or 17 in such a way that the light conducting step is performed simultaneously in a plurality, means wherein the steps being performed thus forming an array.

23. A mobile device (600) **wherein:** an input method according to any one of the preceding claims 15-22 is used.

24. An input device comprising:

- **a** light source (100) emitting light (101) of at least one wavelength $\lambda$;
- a substrate (105) in communication with said light source (100) for guiding the light (101) of wavelength $\lambda$ by total internal reflection;
- an input area (102) located on an outer surface (301) of the substrate;
- detector means (121) for detecting the presence of an object (200) on or at a distance $d \leq \lambda$ above said input area (102) by measuring intensity of light (103) reflected or scattered by said object (200); and
- means (210) for generating a signal (IS) indicating an input action whenever the measured intensity of the reflected or scattered light (103) changes by a predetermined amount or exceeds a predetermined threshold.

25. An input method **comprising** the following steps:

- guiding light (101) of at least one wavelength $\lambda$ inside a substrate (105) by total internal reflection;
- positioning an object (200) on or at a distance of $d \leq \lambda$ above an input area (102) located on an outer surface (301) of said substrate;
- detecting the presence of the object (200) by measuring the intensity of light (103) reflected or scattered by the object (200); and
- generating a signal (IS) indicating an input action whenever the measured intensity of the reflected or scattered light (103) changes by a predefined amount or exceeds a predefined threshold.

26. A method according to claim 25,
    **characterised in that**
    the presence of the object (200) is detected by measuring the intensity of light (103) escaping from a substrate (105) surface located opposite the input area (102).

EP 1 400 918 A1

101

100

105

$n_2$

$n_1$

111

F

DET DET DET ... DET

121(1) 121(2) 121(3) 121(n)

210 CONTROL CIRCUIT IS

# FIG 1 (LEFT)

200

100

103 102 101 105

$n_2$

$n_1$ 111

F

DET DET DET ... DET

SIG 121(1) 121(2) 121(3) 121(n)

210 CONTROL CIRCUIT IS

# FIG 2 (RIGHT)

FIG 3

FIG 4

EP 1 400 918 A1

**FIG 5**

POWER SUPPLY ~505

DISPLAY ~503

CPU ~501

TX/RX ~509

REGISTER ~507

CONTROL CIRCUIT ~210

DET 121(1)   DET 121(2)   DET 121(3)   ...   DET 121(n)

**FIG 6**

~600

~610

~620

EP 1 400 918 A1

EP 1 400 918 A1

# FIG 7

```
                    600
          ┌──────────────┐
          │ ┌──────────┐ │
          │ │100 100 100│ │
          │ │(1) (2) (3)│610
          │ │  ⌇  ⌇  ⌇ │ │
          │ │ ●   ●   ●│ │
          │ └─────────╱105
   701D⌇──┤ ▨   ▨   ▨ │
   701⌇───┤ ▨   ▨   ▨ │
          │ ▨   ▨   ▨ │
          │ ▨   ▨   ▨ │
          │ ▨   ▨   ▨ │
          └──┬───┬───┬──┘
            111 111 111
            (1)  (2)  (3)
```

# FIG 8

```
                    600
          ┌──────────────┐
          │ ┌──────────┐ │
          │ │100 100 100│ │
          │ │(1) (2) (3)│610
          │ │  ⌇  ⌇  ⌇ │ │
          │ │ ●   ●   ●│ │
          │ └─────────╱105
  801D⌇───┤ 1   2   3 │
  801⌇────┤ 4   5   6 │
          │ 7   8   9 │
          │ R   0   M │
          └──┬───┬───┬──┘
            111 111 111
            (1)  (2)  (3)
```

**European Patent Office**

## EUROPEAN SEARCH REPORT

Application Number

EP 02 02 0888

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DE 198 56 008 A (BAYER AG) 21 June 2000 (2000-06-21) * the whole document * | 1-26 | G06K11/08 |
| X | WO 01 26226 A (MICROSOFT CORP) 12 April 2001 (2001-04-12) * page 10, line 2 - line 17; figures 4,5 * | 1,2,6, 15,16, 19,24-26 | |
| X | US 4 254 333 A (BERGSTROEM ARNE) 3 March 1981 (1981-03-03) * column 5, line 5 - line 35; figures 1-4 * | 1,2,6, 15,16, 19,24-26 | |

TECHNICAL FIELDS SEARCHED (Int.Cl.7)

G06K

The present search report has been drawn up for all claims

| Place of search | Date of completion of the search | Examiner |
|---|---|---|
| MUNICH | 19 February 2003 | Fichter, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 02 0888

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2003

| Patent document cited in search report | | Publication date | Patent family member(s) | | Publication date |
|---|---|---|---|---|---|
| DE 19856008 | A | 21-06-2000 | DE 19856008 A1<br>AU 1556100 A<br>WO 0034914 A1 | | 21-06-2000<br>26-06-2000<br>15-06-2000 |
| WO 0126226 | A | 12-04-2001 | WO 0126226 A1 | | 12-04-2001 |
| US 4254333 | A | 03-03-1981 | NONE | | |

EPO FORM P0459

For more details about this annex : see Official Journal of the European Patent Office, No. 12/82